# FASCICULE DE BREVET EUROPEEN

(11) **EP 3 531 228 B1**
(45) Date de publication et mention de la délivrance du brevet: **27.03.2024**
(21) Numéro de dépôt: 19159837.4
(22) Date de dépôt: 27.02.2019
(51) Int. Cl.: G05F 1/56, G05F 1/618, H02M 7/493

(54) **CIRCUIT DE COMMANDE D'INTERRUPTEURS DE PUISSANCE**
SCHUTZSCHALTKREIS VON LEISTUNGSSCHALTERN
POWER SWITCH CONTROL CIRCUIT

(30) Priorité: 27.02.2018 FR 1851699
(43) Date de publication de la demande: 28.08.2019
(73) Titulaire: STMicroelectronics S.r.l., 20864 Agrate Brianza (MB) (IT); STMicroelectronics, Inc., Coppell, TX 75019 (US); STMicroelectronics (ALPS) SAS, 38000 Grenoble (FR)
(72) Inventeur: POLETTO, Vanni, 20151 Milano (IT); SWANSON, David F, Belleville, MI Michigan 48111 (US); TORRISI, Giovanni Luca, 95022 Aci Catena (CT) (IT); CHEVALIER, Laurent, 38650 Roissard (FR)
(74) Mandataire: Cabinet Beaumont

(56) Documents cités:
- JP-B1- 6 282 331
- US-A1- 2014 346 864

## Description

### Domaine

La présente description concerne le domaine des circuits de commande et plus particulièrement les circuits de commande d'interrupteurs de puissance connectés en parallèle.

### Exposé de l'art antérieur

Un pont en H est une structure électronique servant à commander la polarité aux bornes d'un dipôle, constituant la charge et représentant la branche du pont. Le pont est composé de quatre éléments de commutation. Plus précisément, une première borne de la charge est couplée à une première borne d'application d'un potentiel par un premier interrupteur et à une seconde borne d'application d'un potentiel par un deuxième interrupteur. Similairement, la seconde borne du dipôle est couplée à la première borne par un troisième interrupteur et à la seconde borne par un quatrième interrupteur.

Cette structure se retrouve dans de nombreuses applications de l'électronique de puissance incluant la commande des moteurs, les convertisseurs et hacheurs, les onduleurs, etc.

Le document US 2014/0346864 divulgue un dispositif pour maintenir la tension durant le démarrage pour un véhicule motorisé. Le document JP6282331 divulgue un convertisseur de puissance.

### Résumé

L'invention est définie par un système selon la revendication 1 et un système selon la revendication 2. D'autres modes de réalisation préférés sont définis dans les revendications dépendantes.

Le système comprend au moins deux ensembles de transistors et un circuit de commande des ensembles de transistors comprenant chacun un premier transistor et un deuxième transistor reliés en série entre des première et deuxième bornes d'alimentation, le courant du point milieu de chaque ensemble de transistors en série étant régulé selon la différence entre la somme de valeurs représentatives des courants des points milieu de tous les ensembles et la somme de valeurs de consigne affectées aux ensembles.

Les courants des points milieu sont régulés de manière à être sensiblement identiques.

Les grilles de chaque ensemble de transistors sont reliées à un étage comprenant un sommateur et un dispositif de mesure d'une valeur représentative du courant du point milieu de l'ensemble de transistors correspondant.

Un des étages comprend un correcteur recevant en entrée ladite différence.

Le correcteur est un correcteur proportionnel intégral.

La sortie du correcteur recevant ladite différence est fournie à la grille d'au moins un des transistors de chaque ensemble de transistors.

L'autre transistor de l'ensemble est commandé pour avoir l'état inverse.

Le circuit de commande est un circuit intégré.

Selon un mode de réalisation, au moins une partie des transistors en parallèle fait partie du circuit intégré.

Chaque transistor fait partie d'un pont en H.

Selon un autre mode de réalisation, des transistors de chaque pont en H sont externes au circuit intégré.

Les consignes des étages sont identiques.

Le circuit comprend entre deux et six étages.

Un autre mode de réalisation prévoit le circuit de commande étant une puce de circuit intégré.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 illustre, schématiquement, une charge connectée dans la branche de trois ponts en H en parallèle ;
la figure 2 illustre, schématiquement et partiellement, un mode de réalisation d'un circuit de commande d'un étage des ponts de la figure 1 ;
la figure 3 illustre, schématiquement et partiellement, un autre mode de réalisation d'un circuit de commande d'un étage des ponts de la figure 1 ; et
la figure 4 illustre un exemple d'application des modes de réalisation des figures 2 et 3.

### Description détaillée

De mêmes éléments ont été désignés par de mêmes références dans les différentes figures. Par souci de clarté, seuls les éléments utiles à la compréhension des modes de réalisation décrits ont été représentés et sont détaillés. En particulier, les circuits de commande comprennent divers éléments, par exemple des circuits logiques, un microprocesseur, etc., qui ne seront pas détaillés.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence à l'orientation des éléments concernés dans les figures.

Sauf précision contraire, les expressions "approximativement", "sensiblement", et "de l'ordre de" signifient à 10 % près, de préférence à 5 % près.

Sauf précision contraire, lorsque l'on fait référence à deux éléments connectés entre eux, cela signifie que ces éléments sont directement connectés sans élément intermédiaire autre que des conducteurs, et lorsque l'on fait référence à deux éléments reliés ou couplés entre eux, cela signifie que ces deux éléments peuvent être directement reliés (connectés) ou reliés par l'intermédiaire d'un ou plusieurs autres éléments.

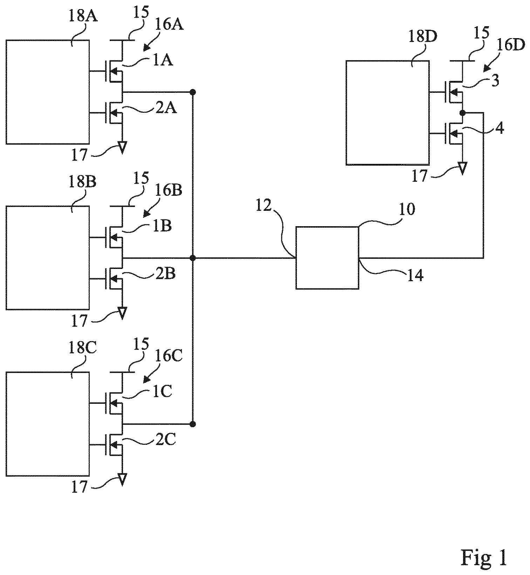

La figure 1 illustre, schématiquement, un dipôle constituant une charge 10. La charge 10, par exemple un moteur, comprend une borne 12 et une borne 14. La charge 10 est située dans la branche de trois ponts en H en parallèle.

Chaque pont en H comprend un premier (1A, 1B ou 1C) et un deuxième (2A, 2B et 2C) interrupteurs connectés en série entre une première (15) et une seconde (17) bornes d'application d'une tension d'alimentation, le potentiel de la première borne 15 étant supérieur à celui de la deuxième borne 17. Chaque couple, ou paire de premier et deuxième interrupteurs d'un pont en H constitue un ensemble 16A, 16B ou 16C. Les trois ponts comprennent, de plus, des troisième 3 et quatrième 4 interrupteurs, constituant un ensemble 16D, commun aux trois ponts. Les troisième et quatrième interrupteurs sont connectés en série entre les bornes 15 et 17. Les premiers et troisième interrupteurs sont connectés à la première borne 15 et les deuxièmes et quatrième interrupteurs sont connectés à la seconde borne 17.

Dans la présente description, on considère que la tension entre les bornes 15 et 17 est une tension positive référencée à la masse (borne 17). Cependant, il est par exemple possible que la tension soit une tension négative référencée à la masse (borne 15).

La borne 12 de la charge 10 est couplée aux points milieu des premiers et deuxièmes interrupteurs des trois ponts en H. La borne 14 de la charge 10 est couplée au point milieu des troisième 3 et quatrième 4 interrupteurs communs à tous les ponts en H en parallèle.

Dans l'exemple de la figure 1, chaque interrupteur de chaque ensemble 16A, 16B, 16C et 16D est un transistor.

Les transistors de chaque ensemble 16A, 16B, 16C ou 16D sont respectivement commandés par un étage 18A, 18B, 18C ou 18D. Les étages 18A, 18B, 18C fournissent en sortie un signal de commande au transistor 1A, 1B ou 1C, connecté à la borne 15, et au transistor 2A, 2B ou 2C, connecté à la borne 17. Les deux transistors d'un même ensemble 16A, 16B ou 16C sont configurés de manière à être dans des états inverses. Ainsi, lorsque l'un des deux est passant, l'autre est bloquant. De même, l'étage 18D fournit en sortie un signal de commande au transistor 3, connecté à la borne 15, et au transistor 4, connecté à la borne 17.

Les transistors des ensembles 16A, 16B et 16C peuvent être commandés de diverses manières connues, par exemple en modulation de largeur d'impulsion (PWM), ou en modulation de fréquence (PFM), ou en modulation linéaire de tension de grille.

Une telle structure permet d'augmenter le courant fourni à la charge 10 tout en minimisant la dissipation de chaleur et la résistance équivalente à l'état passant dans le commutateur.

Cependant, il est préférable que les commandes des transistors ayant des fonctions similaires dans les trois ponts, par exemple les transistors 1A, 1B et 1C ou les transistors 2A, 2B et 2C, soient identiques, c'est-à-dire par exemple que les sorties des étages 18A, 18B et 18C soient identiques. Si au moins un des signaux de commande est suffisamment élevé, la limite de température ou de surintensité de courant de l'un des ponts peut être atteinte et le système peut s'arrêter alors que la limite sur l'ensemble des transistors n'est pas atteinte, les autres signaux ayant une valeur suffisamment faible. Une telle différence entre les signaux de commande de deux transistors est par exemple causée par des variations de certaines caractéristiques (tension de seuil, gain, capacités intrinsèques, résistance à l'état passant, température de fonctionnement, courant individuel de protection, etc.) des composants du circuit de commande.

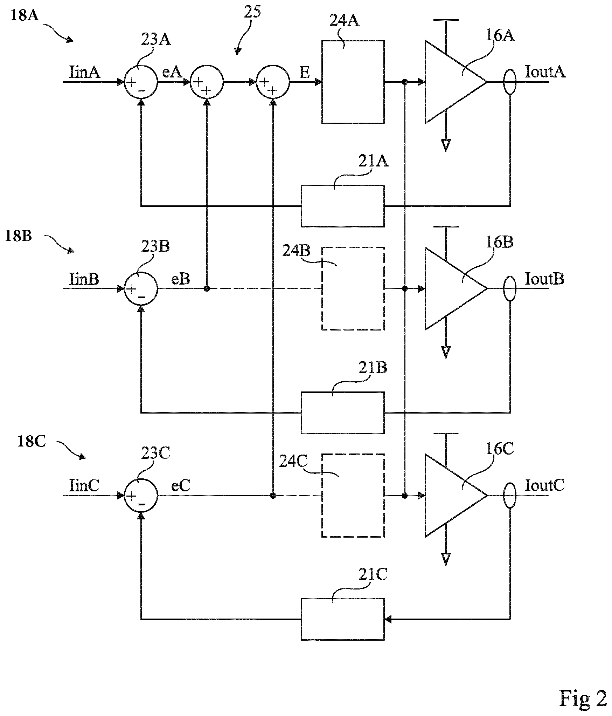

La figure 2 illustre, schématiquement et partiellement, un mode de réalisation d'un circuit de commande commandant les ensembles 16A, 16B et 16C.

Chaque étage 18A, 18B et 18C comprend une boucle de rétroaction dont la sortie est le point milieu des transistors de l'ensemble 16A, 16B ou 16C correspondant.

Chacun des courants IoutA, IoutB, IoutC, c'est-à-dire les courants des points milieu des ensembles 16A, 16B et 16C, est mesuré par un dispositif de mesure 21A, 21B ou 21C qui fournit une valeur représentative du courant IoutA, IoutB, ou IoutC correspondant. Cette valeur est ensuite soustraite, par un sommateur 23A, 23B ou 23C, à une valeur de consigne (IinA, IinB, IinC) affectée à cet ensemble de transistors de manière à obtenir l'erreur eA, eB ou eC de l'étage.

Les erreurs eA, eB et eC sont ensuite additionnées, par des sommateurs 25, par exemple situé dans l'étage 18A, de manière à obtenir une erreur totale E. Cette erreur E est fournie à un correcteur de l'un des étages. Dans l'exemple de la figure 2, ce correcteur est un correcteur 24A de l'étage 18A. Le correcteur 24A est par exemple un correcteur proportionnel-intégral ou un correcteur proportionnel-intégral-dérivé.

La sortie du correcteur 24A fournit directement le signal de commande des ensembles 16A, 16B et 16C. Les transistors des ensembles 16A, 16B et 16C, sensiblement identiques, reçoivent donc en entrée le même signal. Eventuellement, un des transistors de chaque ensemble 16A, 16B et 16C peut recevoir le signal de commande par l'intermédiaire d'un circuit configuré pour que ce transistor ait l'état inverse de l'autre transistor du même ensemble. Les courants IoutA, IoutB et IoutC sont ainsi sensiblement identiques. Cela permet donc d'éviter les déséquilibres en termes de puissance dissipée dans chacun des ensembles de transistors 16A, 16B et 16C. Cela a aussi pour avantage d'éviter qu'un étage s'approche du seuil de température ou de surintensité à partir duquel le système s'éteint. Ainsi, la somme des courants fournie à la charge peut être supérieure. En effet, il n'est pas besoin de maintenir une aussi grande marge entre les valeurs des courants et le seuil.

Additionnellement, les étages 18B et 18C peuvent aussi comprendre des correcteurs 24B et 24C, représentés en pointillés, pouvant être similaires au correcteur 24A. Les étages 18A, 18B et 18C peuvent aussi comprendre des interrupteurs, non représentés, entre les correcteurs 24B et 24C et les sommateurs 23B et 23C et entre les étages 18B et 18C, d'une part et 18A d'autre part. Ainsi, il est possible de choisir si l'on souhaite que les étages 18A, 18B et 18C régulent chacun le courant du point milieu de l'ensemble de transistors correspondant de manière indépendante selon la sortie de leur propre correcteur recevant en entrée une erreur eA, eB ou eC ou que lesdits courants soient régulées ensemble selon la sortie d'un unique correcteur recevant en entrée l'erreur totale E. Il est aussi possible de choisir de réguler certains étages indépendamment et d'en réguler d'autres ensemble.

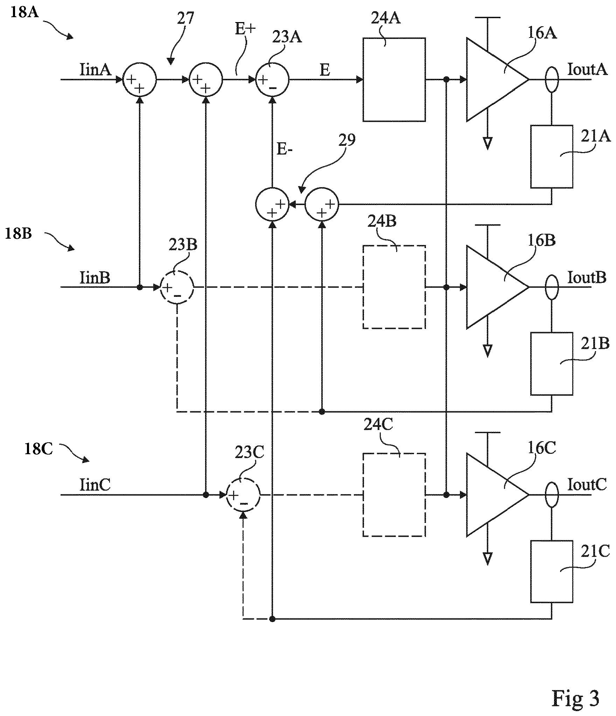

La figure 3 illustre, schématiquement et partiellement, un autre mode de réalisation d'un circuit de commande. Comme la figure 2, la figure 3 représente les étages 18A, 18B et 18C. Chaque étage 18A, 18B et 18C comprend, comme en figure 2, une boucle rétroactive dans laquelle une valeur représentative du courant IoutA, IoutB ou IoutC du point milieu des transistors de l'ensemble 16A, 16B ou 16C peut être soustraite à une valeur de consigne IinA, IinB ou IinC. Chaque étage 18A, 18B et 18C comprend donc le dispositif de mesure 21A, 21B ou 21C mesurant la valeur représentative du courant IoutA, IoutB ou IoutC, le sommateur 23A, 23B ou 23C, et le correcteur 24A, 24B ou 24C.

Les valeurs des consignes des étages 18A, 18B et 18C sont additionnées, par des sommateurs 27, de manière à obtenir une valeur E+. Les valeurs représentatives du courant IoutA, IoutB ou IoutC mesuré à chaque étage sont additionnées par des sommateurs 29 de manière à obtenir une valeur E-. On soustrait, par le sommateur 23A, la valeur E- à la valeur E+. Le résultat obtenu de cette manière est l'erreur totale E. Cette erreur E correspond à l'erreur E de la figure 2. Cette erreur E est fournie au correcteur 24A de l'étage 18A, dont la sortie est la commande des ensembles 16A, 16B et 16C. Les courants IoutA, IoutB et IoutC sont ainsi régulés, selon l'erreur totale E, de manière à être sensiblement identiques.

De même que précédemment, le circuit de commande peut comprendre des interrupteurs, non représentés, entre les différents étages du circuit et entre les correcteurs 24B et 24C, d'une part, et les sommateurs 23B et 23C d'autre part. Ainsi, comme cela est décrit en relation avec la figure 2, il est possible pour les différents étages d'agir indépendamment les uns des autres, ou d'être tous régulés selon la sortie du correcteur 24A.

Dans le mode de réalisation de la figure 2 ou celui de la figure 3, les consignes des étages d'un circuit de commande peuvent être sensiblement identiques. A titre de variante, les consignes des étages d'un circuit de commande peuvent être différentes les unes des autres. Leur somme est cependant égale à la somme des valeurs des courants IoutA, IoutB, et IoutC, sensiblement identiques, voulue.

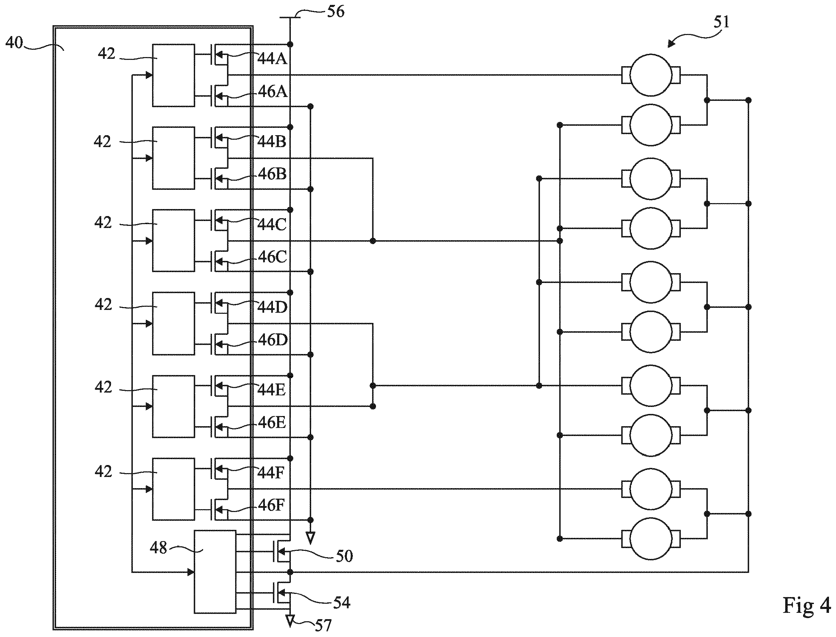

La figure 4 est un exemple d'application des modes de réalisation de circuits de commande des figures 2 et 3.

La figure 4 représente une puce de circuit intégré 40 et des moteurs 51. Les moteurs sont par exemple des moteurs de voiture permettant l'ouverture et la fermeture des fenêtres, des portes ou du coffre, etc.

La puce 40 comprend six étages 42 fournissant chacun le signal de commande d'un transistor 44 (44A, 44B, 44C, 44D, 44E, 44F) et d'un transistor 46 (46A, 46B, 46C, 46D, 46E, 46F). Les transistors 44 et 46 constituent les premiers et deuxièmes interrupteurs de ponts en H. Chaque couple de transistors 44 et 46 est connecté en série entre une première (56) et une seconde (57) bornes d'application d'une tension d'alimentation, comme cela a été décrit en relation avec la figure 1.

La puce 40 comprend, de plus, un étage 48 fournissant le signal de commande d'un transistor 50 et d'un transistor 54. Les transistors 52 et 54 constituent les troisième et quatrième interrupteurs communs à l'ensemble des ponts en H. Les transistors 50 et 54 sont connectés en série entre une première (56) et une seconde (57) bornes d'application d'une tension d'alimentation, comme cela a été décrit en relation avec la figure 1.

Les transistors 44 et 46 sont des transistors situés dans le circuit intégré. Les transistors 50 et 54 sont des transistors externes au circuit intégré. En effet, les transistors 50 et 54 étant communs à tous les ponts en H, ils doivent dissiper plus de chaleur que chaque ensemble de deux transistors 44 et 46. Des transistors externes au circuit intégré peuvent plus facilement dissiper la chaleur de l'ensemble des ponts en H.

Le pont en H comprenant les transistors 44A et 46A et celui comprenant les transistors 44F et 46F ne sont en parallèle avec aucun autre pont et leur charge respective est un unique moteur.

Le noeud entre les transistors 44B et 46B, et celui entre les transistors 44C et 46C, sont connectés et les deux ponts en H correspondants sont en parallèle. La charge commune de ces deux ponts en parallèle comprend cinq moteurs.

Les ponts en H comprenant les transistors 44D, 46D, 44E et 46E sont aussi en parallèle et leur charge commune comprend trois moteurs.

Un avantage des modes de réalisation décrits précédemment est que le risque d'atteindre la limite de température ou de surintensité de courant de l'un des ponts et donc d'arrêter le système est moindre.

Des modes de réalisation particuliers ont été décrits. Diverses variantes et modifications apparaîtront à l'homme de l'art. En particulier, bien que les figures 2 et 3 représentent des circuits de commande comprenant trois étages, le nombre d'étages, et donc d'ensembles de transistors commandés par le circuit de commande, peut être autre que trois. Le nombre d'étages est de préférence supérieur à deux. Par exemple, le nombre d'étages peut être compris entre deux et six.

De plus, bien que les circuits de commande décrits commandent des transistors constituant des ponts en H, les modes de réalisation décrits sont néanmoins adaptables à des circuits commandant n'importe quelle structure de transistors en parallèle interne ou externe au circuit intégré. Un mode de réalisation dans lequel la borne 14 (figure 1) est reliée à la masse, à une source d'alimentation ou à un autre circuit est également possible.

Divers modes de réalisation avec diverses variantes ont été décrits ci-dessus. L' invention est définie par les revendications annexées.

## Revendications

1. Système comprenant au moins deux ensembles (16A, 16B, 16C) de transistors et un circuit de commande des ensembles (16A, 16B, 16C) de transistors, chaque ensemble (16A, 16B, 16C) de transistors comprenant un premier transistor (1A, 1B, 1C) et un deuxième transistor (2A, 2B, 2C) reliés en série entre des première (15, 56) et deuxième (17, 57) bornes d'alimentation, **caractérisé en ce que** :
le circuit de commande est configuré pour fournir un signal de commande respectif de chaque ensemble (16A, 16B, 16C) de transistors, le circuit de commande étant configuré pour réguler des courants du point milieu (IouA, IoutB, IoutC) respectifs de tous les ensembles (16A, 16B, 16C) de transistors selon une différence (E) entre une somme de valeurs représentatives des courants des points milieu (IoutA, IoutB, IoutC) respectifs de tous les ensembles (16A, 16B, 16C) de transistors et une somme des valeurs de consigne (IinA, IinB, IinC) affectées aux ensembles (16A, 16B, 16C) de transistors, de sorte que les courants des points milieu (IoutA, IoutB, IoutC) respectifs soient sensiblement identiques, le point milieu (IoutA, IoutB, IoutC) respectif de chaque ensemble (16A, 16B, 16C) de transistors correspondant au point de connexion du premier transistor (1A, 1B, 1C) avec le deuxième transistor (2A, 2B, 2C) dudit ensemble,
le circuit de commande comprend, pour chaque ensemble (16A, 16B, 16C) de transistors, un étage comprenant un sommateur (23A, 23B, 23C) et un dispositif de mesure (21A, 21B, 21C) de la valeur représentative du courant du point milieu (IoutA, IoutB, IoutC) respectif de l'ensemble (16A, 16B, 16C) de transistors, le sommateur (23A, 23B, 23C) de chaque étage étant configuré pour soustraire la valeur représentative du courant du point milieu (IoutA, IoutB, IoutC) dudit ensemble (16A, 16B, 16C) de transistors à la valeur de consigne (IinA, IinB, IinC) affectée audit ensemble (16A, 16B, 16C) de transistors, le sommateur (23A, 23B, 23C) de chaque étage étant configuré pour fournir une erreur (eA, eB, eC), les grilles de chaque ensemble (16A, 16B, 16C) de transistors étant reliées à l'étage correspondant,
le circuit de commande comprend en outre un circuit sommateur (25) configuré pour additionner les erreurs (eA, eB, eC) respectives des sommateurs (23A, 23B, 23C) de chaque étage, de manière à obtenir la différence (E),
un des étages comprend un correcteur (24A) configuré pour recevoir en entrée ladite différence et pour fournir en sortie les signaux de commande respectifs des ensembles (16A, 16B, 16C) de transistors.

2. Système comprenant au moins deux ensembles (16A, 16B, 16C) de transistors et un circuit de commande des ensembles (16A, 16B, 16C) de transistors, chaque ensemble (16A, 16B, 16C) de transistors comprenant un premier transistor (1A, 1B, 1C) et un deuxième transistor (2A, 2B, 2C) reliés en série entre des première (15, 56) et deuxième (17, 57) bornes d'alimentation, **caractérisé en ce que** :
le circuit de commande est configuré pour fournir un signal de commande respectif de chaque ensemble (16A, 16B, 16C) de transistors, le circuit de commande étant configuré pour réguler des courants du point milieu (IouA, IoutB, Toute) respectifs de tous les ensembles (16A, 16B, 16C) de transistors selon une différence (E) entre une somme de valeurs représentatives des courants des points milieu (IoutA, IoutB, IoutC) respectifs de tous les ensembles (16A, 16B, 16C) de transistors et une somme des valeurs de consigne (IinA, IinB, IinC) affectées aux ensembles (16A, 16B, 16C) de transistors, de sorte que les courants des points milieu (IoutA, IoutB, IoutC) respectifs soient sensiblement identiques, le point milieu (IoutA, IoutB, IoutC) respectif de chaque ensemble (16A, 16B, 16C) de transistors correspondant au point de connexion du premier transistor (1A, 1B, 1C) avec le deuxième transistor (2A, 2B, 2C) dudit ensemble,
le circuit de commande comprend, pour chaque ensemble (16A, 16B, 16C) de transistors, un circuit de mesure (21A, 21B, 21C) de la valeur représentative du courant du point milieu (IoutA, IoutB, IoutC) de l'ensemble (16A, 16B, 16C) de transistors, le circuit de commande comprenant en outre :
- un premier circuit sommateur (27) configuré pour additionner les valeurs de consigne (IinA, IinB, IinC) affectées aux ensembles (16A, 16B, 16C) de transistors, de manière à obtenir une première valeur d'erreur (E+),
- un deuxième circuit sommateur (29) configuré pour additionner les valeurs représentatives des courants des points milieu (IoutA, IoutB, IoutC), de manière à obtenir une seconde valeur d'erreur (E-),
- un troisième circuit sommateur (23A) configuré pour soustraire la seconde valeur d'erreur (E-) à la première valeur d'erreur (E+), de manière à obtenir la différence (E), et
- un correcteur (24A) configuré pour recevoir en entrée ladite différence (E) et pour fournir en sortie les signaux de commande respectifs des ensembles (16A, 16B, 16C) de transistors.

3. Système selon la revendication 1 ou la revendication 2, dans lequel le correcteur est un correcteur proportionnel intégral.

4. Système selon l'une quelconque des revendications 1 à 3, dans lequel la sortie du correcteur configurée pour recevoir ladite différence est configuré pour être fournie à la grille d'au moins un des transistors de chaque ensemble de transistors.

5. Système selon la revendication 4, dans lequel l'autre transistor de l'ensemble est configuré pour être commandé pour avoir l'état inverse.

6. Système selon l'une quelconque des revendications 1 à 5, dans lequel le circuit de commande est un circuit intégré.

7. Système selon la revendication 6, dans lequel au moins une partie des transistors en parallèle fait partie du circuit intégré.

8. Système selon l'une quelconque des revendications 1 à 7, dans lequel le circuit de commande comprend au moins deux ponts en H, chaque transistor faisant partie d'un pont en H.

9. Système selon la revendication 6, dans lequel le circuit de commande comprend au moins deux ponts en H, chaque transistor faisant partie d'un pont en H, et dans lequel des transistors de chaque pont en H sont externes au circuit intégré.

10. Système selon l'une quelconque des revendications 1 à 9, dans lequel les valeurs de consigne des étages sont identiques.

11. Système selon l'une quelconque des revendications 1 à 10, dans lequel le circuit comprend entre deux et six étages.

12. Système selon l'une quelconque des revendications 1 à 11, dans lequel le circuit de commande est une puce (40) de circuit intégré.

## Patentansprüche

1. Ein System, das wenigstens zwei Anordnungen (16A, 16B, 16C) von Transistoren und eine Steuerschaltung der Anordnungen (16A, 16B, 16C) aufweist, wobei jede Anordnung (16A, 16B, 16C) von Transistoren einen ersten Transistor (1A, 1B, 1C) und einen zweiten Transistor (2A, 2B, 2C) aufweist, die in Reihe zwischen einem ersten (15, 56) und einem zweiten (17, 57) Versorgungsknoten gekoppelt sind,
**dadurch gekennzeichnet, dass**
die Steuerschaltung eingerichtet ist, ein Steuersignal jeweils für jede Anordnung (16A, 16B, 16C) von Transistoren bereitzustellen, wobei die Steuerschaltung eingerichtet ist, jeweils Mittenströme (IoutA, loutB, IoutC) für alle Anordnungen (16A, 16B, 16C) von Transistoren zu regeln gemäß einer Differenz (E) zwischen einer Summe von Werten, die für Mittenströme (IoutA, loutB, IoutC) aller Anordnungen (16A, 16B, 16C) von Transistoren repräsentativ sind, und einer Summe von Sollwerten (IinA, linB, linC), die den Anordnungen (16A, 16B, 16C) von Transistoren zugeordnet sind, so dass die jeweiligen Mittenströme (IoutA, loutB, IoutC) im Wesentlichen identisch sind, wobei der Mittelpunkt (IoutA, IoutB, IoutC) jeder Anordnung (16A, 16B, 16C) von Transistoren dem Verbindungspunkt des ersten Transistors (1A, 1B, 1C) mit dem zweiten Transistor (2A, 2B, 2C) der Anordnung entspricht, die Steuerschaltung für jede Anordnung (16A, 16B, 16C) von Transistoren eine Stufe aufweist, die einen Addierer (23A, 23B, 23C) und eine Vorrichtung (21A, 21B, 21C) zum Messen des Werts aufweist, der repräsentativ für den Mittenstrom (IoutA, loutB, IoutC) der jeweiligen Anordnung (16A, 16B, 16C) von Transistoren ist, wobei der Addierer (23A, 23B, 23C) jeder Stufe eingerichtet ist, den Wert, der repräsentativ für den Mittenstrom (IoutA, loutB, loutC) der Anordnung (16A, 16B, 16C) von Transistoren ist, von dem Sollwert (IinA, linB, linC), der der Anordnung (16A, 16B, 16C) von Transistoren zugewiesenen ist, zu subtrahieren, wobei der Addierer (23A, 23B, 23C) jeder Stufe eingerichtet ist, einen Fehler (eA, eB, eC) zu liefern, wobei die Gates jeder Anordnung (16A, 16B, 16C) von Transistoren mit der entsprechenden Stufe gekoppelt sind,
die Steuerschaltung ferner eine Additionsschaltung (25) aufweist, die eingerichtet ist, die jeweiligen Fehler (eA, eB, eC) der Addierer (23A, 23B, 23C) jeder Stufe zu addieren, um die Differenz (E) zu erhalten, eine der Stufen einen Korrektor (24A) aufweist, der eingerichtet ist, als Eingang die Differenz zu empfangen und als Ausgang die jeweiligen Steuersignale der Anordnungen (16A, 16B, 16C) von Transistoren zu liefern.

2. Ein System, das wenigstens zwei Anordnungen (16A, 16B, 16C) von Transistoren und eine Steuerschaltung der Anordnungen (16A, 16B, 16C) aufweist, wobei jede Anordnung (16A, 16B, 16C) von Transistoren einen ersten Transistor (1A, 1B, 1C) und einen zweiten Transistor (2A, 2B, 2C) aufweist, die in Reihe zwischen einem ersten (15, 56) und einem zweiten (17, 57) Versorgungsknoten gekoppelt sind,
**dadurch gekennzeichnet, dass**
die Steuerschaltung eingerichtet ist, ein Steuersignal jeweils für jede Anordnung (16A, 16B, 16C) von Transistoren bereitzustellen, wobei die Steuerschaltung eingerichtet ist, jeweils Mittenströme (IoutA, loutB, IoutC) für alle Anordnungen (16A, 16B, 16C) von Transistoren zu regeln gemäß einer Differenz (E) zwischen einer Summe von Werten, die für Mittenströme (IoutA, loutB, IoutC) aller Anordnungen (16A, 16B, 16C) von Transistoren repräsentativ sind, und einer Summe von Sollwerten (IinA, linB, linC), die den Anordnungen (16A, 16B, 16C) von Transistoren zugeordnet sind, so dass die jeweiligen Mittenströme (IoutA, loutB, IoutC) im Wesentlichen identisch sind, wobei der Mittelpunkt (IoutA, IoutB, IoutC) jeder Anordnung (16A, 16B, 16C) von Transistoren dem Verbindungspunkt des ersten Transistors (1A, 1B, 1C) mit dem zweiten Transistor (2A, 2B, 2C) der Anordnung entspricht, die Steuerschaltung für jede Anordnung (16A, 16B, 16C) von Transistoren eine Schaltung (21A, 21B, 21C) zum Messen des Wertes aufweist, der repräsentativ für den Mittenstrom (IoutA, loutB, loutC) der Anordnung (16A, 16B, 16C) von Transistoren ist, wobei die Steuerschaltung ferner Folgendes aufweist:
- eine erste Additionsschaltung (27), die eingerichtet ist, die den Anordnungen (16A, 16B, 16C) von Transistoren zugeordneten Sollwerte (IinA, linB, linC) zu addieren, um einen ersten Fehlerwert (E+) zu erhalten,
- eine zweite Additionsschaltung (29), die eingerichtet ist, die Werte, die repräsentativ für die Mittenströme (IoutA, loutB, IoutC) sind, zu addieren, um einen zweiten Fehlerwert (E-) zu erhalten,
- eine dritte Additionsschaltung (23A), die eingerichtet ist, den zweiten Fehlerwert (E-) von dem ersten Fehlerwert (E+) zu subtrahieren, um die Differenz (E) zu erhalten, und
- einen Korrektor (24A), der eingerichtet ist, als Eingang die Differenz (E) zu empfangen und als Ausgang die jeweiligen Steuersignale der Anordnungen (16A, 16B, 16C) von Transistoren zu liefern.

3. System nach Anspruch 1 oder Anspruch 2, wobei der Korrektor ein proportional-integraler Korrektor ist.

4. System nach einem der Ansprüche 1 bis 3, wobei der Ausgang des Korrektors, der eingerichtet ist, die Differenz zu empfangen, eingerichtet ist, dem Gate von wenigstens einem der Transistoren jeder Anordnung von Transistoren zugeführt zu werden.

5. System nach Anspruch 4, wobei der andere Transistor der Anordnung eingerichtet ist, so gesteuert zu werden, dass er den entgegengesetzten Zustand annimmt.

6. System nach einem der Ansprüche 1 bis 5, wobei die Steuerschaltung eine integrierte Schaltung ist.

7. System nach Anspruch 6, wobei wenigstens ein Teil der parallel geschalteten Transistoren zur integrierten Schaltung gehört.

8. System nach einem der Ansprüche 1 bis 7, wobei die Steuerschaltung wenigstens zwei H-Brücken aufweist, wobei jeder Transistor zu einer H-Brücke gehört.

9. System nach Anspruch 6, wobei die Steuerschaltung wenigstens zwei H-Brücken aufweist, wobei jeder Transistor zu einer H-Brücke gehört, und wobei die Transistoren jeder H-Brücke außerhalb der integrierten Schaltung liegen.

10. System nach einem der Ansprüche 1 bis 9, wobei die Sollwerte der Stufen identisch sind.

11. System nach einem der Ansprüche 1 bis 10, wobei die Schaltung zwei bis sechs Stufen aufweist.

12. System nach einem der Ansprüche 1 bis 11, wobei die Steuerschaltung ein Chip (40) einer integrierten Schaltung ist.

## Claims

1. A system comprising at least two assemblies (16A, 16B, 16C) of transistors and a control circuit of the assemblies (16A, 16B, 16C), each assembly (16A, 16B, 16C) of transistors comprising a first transistor (1A, 1B, 1C) and a second transistor (2A, 2B, 2C) coupled in series between first (15, 56) and second (17, 57) supply nodes, **characterized in that**
the control circuit is configured to provide a control signal respective of each assembly (16A, 16B, 16C) of transistors, the control circuit being configured to regulate middle point currents (IoutA, IoutB, IoutC) respective of all the assemblies (16A, 16B, 16C) of transistors according to a difference (E) between the sum of values representative of middle point currents (IoutA, IoutB, IoutC) of all the assemblies (16A, 16B, 16C) of transistors and a sum of set values (IinA, IinB, IinC) assigned to the assemblies (16A, 16B, 16C) of transistors so that the respective middle point currents (IoutA, IoutB, IoutC) are substantially identical, the middle point (IoutA, IoutB, IoutC) respective of each assembly (16A, 16B, 16C) of transistors corresponding to the connecting point of the first transistor (1A, 1B, 1C) with the second transistor (2A, 2B, 2C) of said assembly,
the control circuit comprises, for each assembly (16A, 16B, 16C) of transistors, a stage comprising an adder (23A, 23B, 23C) and a device (21A, 21B, 21C) for measuring the representative value of the middle point current (IoutA, IoutB, IoutC) respective of the assembly (16A, 16B, 16C) of transistors, the adder (23A, 23B, 23C) of each stage being configured to substract the representative value of the middle point current (IoutA, IoutB, IoutC) of said assembly (16A, 16B, 16C) of transistors from the set value (IinA, IinB, IinC) assigned to said assembly (16A, 16B, 16C) of transistors, the adder (23A, 23B, 23C) of each stage being configured to provide an error (eA, eB, eC), the gates of each assembly (16A, 16B, 16C) of transistors being coupled to the corresponding stage,
the control circuit further comprises an adding circuit (25) configured to add the errors (eA, eB, eC) respective of the adders (23A, 23B, 23C) of each stage, in order to obtain the difference (E), one of the stages comprises a corrector (24A) configured to receive as an input said difference and to provide as an output the respective control signals of the assemblies (16A, 16B, 16C) of the transistors.

2. A system comprising at least two assemblies (16A, 16B, 16C) of transistors and a control circuit of the assemblies (16A, 16B, 16C), each assembly (16A, 16B, 16C) of transistors comprising a first transistor (1A, 1B, 1C) and a second transistor (2A, 2B, 2C) coupled in series between first (15, 56) and second (17, 57) supply nodes, **characterized in that**
the control circuit is configured to provide a control signal respective of each assembly (16A, 16B, 16C) of transistors, the control circuit being configured to regulate middle point currents (IoutA, IoutB, IoutC) respective of all the assemblies (16A, 16B, 16C) of transistors according to a difference (E) between the sum of values representative of middle point currents (IoutA, IoutB, IoutC) of all the assemblies (16A, 16B, 16C) of transistors and a sum of set values (IinA, IinB, IinC) assigned to the assemblies (16A, 16B, 16C) of transistors so that the respective middle point currents (IoutA, IoutB, IoutC) are substantially identical, the middle point (IoutA, IoutB, IoutC) respective of each assembly (16A, 16B, 16C) of transistors corresponding to the connecting point of the first transistor (1A, 1B, 1C) with the second transistor (2A, 2B, 2C) of said assembly,
the control circuit comprises, for each assembly (16A, 16B, 16C) of transistors, a device (21A, 21B, 21C) for measuring the representative value of the middle point current (IoutA, IoutB, IoutC) respective of the assembly (16A, 16B, 16C) of transistors, the control circuit further comprising:
- a first adding circuit (27) configured to add the set values (IinA, IinB, IinC) assigned to the assemblies (16A, 16B, 16C) of transistors, in order to obtain a first error value (E+),
- a second adding circuit (29) configured to add the representative value of the middle point currents (IoutA, IoutB, IoutC), in order to obtain a second error value (E-),
- a third adding circuit (23A) configured to substract the second error value (E-) from the first error value (E+), in order to obtain the difference (E), and
- a corrector (24A) configured to receive as an input said difference (E)and to provide as an output the respective control signals of the assemblies (16A, 16B, 16C) of the transistors.

3. The system of claim 1 or of claim 2, wherein the corrector is a proportional-integral corrector.

4. The system according to any of claims 1 to 3, wherein the output of the corrector configured to receive said difference is configured to be supplied to the gate of at least one of the transistors of each assembly of transistors.

5. The system of claim 4, wherein the other transistor of the assembly is configured to be controlled in order to have the opposite state.

6. The system according to any of claims 1 to 5, wherein the control circuit is an integrated circuit.

7. The system of claim 6, wherein at least part of the transistors in parallel belongs to the integrated circuit.

8. The system according to any of claims 1 to 7, wherein the control circuit comprises at least two H bridges, each transistor belonging to a H bridge.

9. The system of claim 6, wherein the control circuit comprises at least two H bridges, each transistor belonging to a H bridge, and wherein the transistors of each H bridge are external to the integrated circuit.

10. The system according to any of claims 1 to 9, wherein the set points of the stages are identical.

11. The system according to any of claims 1 to 10, wherein the circuit comprises from two to six stages.

12. The system according to any of claims 1 to 11, wherein the control circuit is chip (40) of integrated circuit.
